# EUROPEAN PATENT APPLICATION

(11) **EP 3 284 849 A1**
(43) Date of publication of application: **21.02.2018**
(21) Application number: 17186716.1
(22) Date of filing: 17.08.2017
(51) Int. Cl.: C25D 5/12, C25D 7/00, C25D 5/10, H01R 13/03, C25D 3/12, C25D 3/48, C25D 3/50, C25D 3/64

(54) **MULTI-LAYER ELECTRICAL CONTACT ELEMENT**

(30) Priority: 18.08.2016 US 201615239917
(71) Applicant: Rohm and Haas Electronic Materials LLC, Marlborough, MA 01752 (US)
(72) Inventor: FOYET, Adolphe, Marlborough, MA 01752 (US); CLAUSS, Margit, Marlborough, MA 01752 (US)
(74) Representative: Houghton, Mark Phillip

(57) **Abstract**

Multi-layer electrical contact elements include a flash palladium layer and an intermediate layer of binary hard silver/tin alloy having good corrosion resistance where inter-diffusion of metals between adjacent layers is inhibited to provide distinct interfaces between adjacent layers.

## Description

### Field of the Invention

The present invention is directed to a multi-layer electrical contact element having good corrosion resistance where inter-diffusion of metals between adjacent layers is inhibited to provide distinct interfaces between adjacent layers. More specifically, the present invention is directed to a multi-layer metal electrical contact element having good corrosion resistance where inter-diffusion of metals between adjacent metal layers is inhibited to provide distinct interfaces between adjacent layers and where the multi-layer metal electrical contact element includes a flash layer containing palladium metal and an intermediate layer of hard binary silver/tin alloy.

### Background of the Invention

Prevention of corrosion of metals is a challenging problem in numerous industries. The corrosion of metals has been especially problematic in the electronic materials industry where corrosion may lead to faulty electrical contacts between components in electronic devices. For example, gold and gold alloy coatings have been used in electronics and other applications for many years. In electronics they have been used as a solderable and corrosion resistive surface for contacts and connectors. They are also used in lead finishes for integrated circuit (IC) fabrication.

IC devices, having IC units, lead frames and passive components, such as capacitors and transistors, find wide use in products including consumer electronics, household appliances, computers, automobiles, telecommunications, robotics and military equipment. The IC unit encompasses IC chips and hybrid circuit nodules which include one or more of the IC chips and other electronic components on a plastic or ceramic support base.

Lead frames or connectors are a means to electrically interconnect an IC unit to external circuitry. The lead frame is formed from electrically conductive material such as copper or copper alloys, or by stamping or etching a metal blank into a plurality of leads defining a central area in which the IC unit is mounted. There are several attachment techniques by which the lead frames connect the IC units in an assembly. These include wirebonding, soldering, die-attach and encapsulation. Typically soldering is the means of joining the IC to the assembly. In all instances attachment requires a particular quality of the lead frame surface. Typically this means that the surface is corrosion free and ready for interaction with other components such as gold or aluminum wire, silver filled epoxy or solder. However, gold finishes may not always prevent corrosion. Corrosion is a natural occurring process because it is thermodynamically favorable. Certain physical properties of gold, such as its relative porosity, translate into problems when gold is deposited onto a substrate. For instance, gold's porosity can create interstices on the plated surface. These small spaces can contribute to corrosion or actually accelerate corrosion through the galvanic coupling of the gold layer with the underlying base metal layer. This is believed to be due to the base metal substrate and any accompanying underlying metal layers which may be exposed to corrosive elements via the pores in the gold outer surface.

In addition, many applications include thermal exposure of coated lead frames. Diffusion of metal between layers under thermal aging conditions may cause a loss of surface quality if an underlying metal diffuses into a noble metal surface layer such as silver into gold.

At least three different approaches to overcoming the corrosion problems have been attempted: 1) reducing the porosity of the coating, 2) inhibiting the galvanic effects caused by the electropotential differences of different metals, and 3) sealing the pores in the electroplated layer. Reducing the porosity has been studied extensively. Pulse plating of the gold and utilization of various wetting/grain refining agents in the gold plating bath affect the gold structure and are two factors contributing to a reduction in gold porosity. Often regular carbon bath treatments and good filtration practices in the series of electroplating baths or tanks combined with a preventive maintenance program help to maintain gold metal deposition levels and correspondingly low levels of surface porosity. A certain degree of porosity, however, continues to remain.

Pore closure, sealing and other corrosion inhibition methods have been tried but with limited success. Potential mechanisms using organic precipitates having corrosion inhibitive effects are known in the art. Many of these compounds were typically soluble in organic solvents and were deemed not to provide long term corrosion protection. Other methods of pore sealing or pore blocking are based on the formation of insoluble compounds inside pores. Such insoluble complexes and precipitates as are apparent to those of skill in the field also are potential candidates for pore blocking.

Although there are methods which attempt to address the corrosion problems on metal deposits, there is still a need for improved methods for inhibiting corrosion.

### Summary of the Invention

The present invention includes a multi-layer electrical contact element comprising:
a substrate comprising a copper or copper alloy layer;
a binary silver/tin alloy layer upon the copper or copper alloy layer, the binary silver/tin alloy layer comprises at least 50% by weight silver; and
a flash layer composed of palladium adjacent the binary silver/tin alloy layer.

The present invention also includes a multi-layer electrical contact element comprising:
a substrate comprising a copper or copper alloy layer;
a nickel layer adjacent to the copper or copper alloy layer;
a binary silver/tin alloy layer adjacent the nickel layer, the binary silver/tin alloy layer comprises at least 50% by weight silver; and
a flash layer composed of palladium adjacent the binary silver/tin alloy layer.

The present invention includes a method of forming a multi-layer electrical contact element comprising:
a) providing a substrate comprising a copper or copper alloy layer;
b) electroplating a binary silver/tin alloy layer adjacent the copper or copper alloy layer of the substrate from a silver/tin alloy electroplating bath, the binary silver/tin alloy comprises at least 50% by weight silver; and
c) electroplating a flash layer of palladium adjacent the binary silver/tin alloy from a palladium electroplating bath.

The present invention further includes a method of forming a multi-layer electrical contact element comprising:
a) providing a substrate comprising a copper or copper alloy layer;
b) electroplating a nickel layer adjacent the copper or copper alloy layer of the substrate from a nickel electroplating bath;
c) electroplating a binary silver/tin alloy layer adjacent the nickel layer from a silver/tin alloy electroplating bath, the binary silver/tin alloy comprises at least 50% by weight silver; and
d) electroplating a flash layer of palladium adjacent the binary silver/tin alloy from a palladium electroplating bath.

The present invention also includes optionally a gold or gold alloy layer adjacent to the palladium layer. The gold or gold alloy layer is electroplated adjacent to the palladium layer. The multi-layer metal electrical contact elements of the present invention have good corrosion resistance. When gold or gold alloy is included adjacent to the palladium layer inter-diffusion of metals between gold and the silver/tin layer is inhibited by the palladium flash layer to provide distinct interfaces between adjacent layers. The multi-layer contact maintains its cosmetic gold finish as well as the electrical properties of the gold finish at both low temperature such as below 100 °C and high temperature such as 100 °C and greater, typically from 120 °C to 200 °C. The palladium layer inhibits corrosion of the adjacent binary silver/tin alloy. The hard binary silver/tin alloy of the present invention also provides good wear resistance for the multi-layer contact element.

### Brief Description of the Invention

Figure 1A illustrates a succession of metal layers of an electric contact element of the present invention.
Figure 1B illustrates a succession of metal layers of an electric contact element of the present invention with an optional gold layer adjacent the palladium flash layer.
Figure 2A illustrates a succession of metal layers of another embodiment of an electric contact element of the present invention where a nickel layer is adjacent to the copper or copper alloy bottom layer.
Figure 2B illustrates a succession of metal layers of another embodiment of an electric contact element of the present invention where a nickel layer is adjacent to the copper or copper alloy bottom layer and where an optional gold layer is adjacent the palladium flash layer.

### Detailed Description of the Invention

As used throughout this embodiment, the following abbreviations have the following meanings, unless the context clearly indicates otherwise: °C = degrees Centigrade; g = gram; mg = milligram; L = liter; mL = milliliter; mm = millimeters; nm = nanometers; nm = 1x10⁻⁹ meters; µm = microns; µm = 1x10⁻⁶ meters; dm = decimeter; A = amperes; ASD = amperes/dm²; sec = seconds; min = minutes; wt% = weight percent; DI = deionized; C = carbon; N = nitrogen; O = oxygen; Ag = silver; Sn = tin; Pd = palladium; Ni = nickel; Au = gold; and Cu = copper.

The terms "depositing", "plating" and "electroplating" are used interchangeably throughout this specification. The term "adjacent" means direct physical contact between two surfaces such that they form a common interface. Unless otherwise specified the solvent for the plating baths is water. All numerical ranges are inclusive and combinable in any order, except where it is logical that such numerical ranges are constrained to add up to 100%.

The present invention includes a multi-layer electrical contact element with a binary silver/tin alloy upon a copper or copper alloy layer. Optionally, the copper or copper alloy layer is joined to a dielectric base substrate. Preferably the layer is copper. When the layer is copper alloy, the alloy is preferably a copper/tin alloy, copper/beryllium or a copper/nickel alloy. The binary silver/tin alloy includes at least 50% by weight silver where tin makes up the remainder of the alloy. Preferably the amount of silver in the alloy is 70% by weight to 95% by weight and the amount of tin is 5% by weight to 30% by weight. More preferably silver is included in the alloy in amounts of 80% by weight to 95% by weight and the tin is in amounts of 5% by weight to 20% by weight.

The binary silver/tin alloy can be electroplated on the copper or copper alloy layer by conventional silver/tin alloy electroplating baths which provide the desired silver and tin content of the alloy. The electroplating baths include one or more sources of silver ions. Sources of silver ions can be provided by silver salts such as, but are not limited to silver halides, silver gluconate, silver citrate, silver lactate, silver nitrate, silver sulfates, silver alkane sulfonates and silver alkanol sulfonates. The silver salts are generally commercially available or can be prepared by methods described in the literature. The amounts of the one or more silver salts used in the baths depend, for example, on the desired alloy composition to be deposited and operating conditions. In general, silver salts in the bath can range from 1 g/L to 100 g/L. To achieve a bright silver rich alloy, the weight concentration of silver ions to tin ions in the electroplating bath can range from 1:1 to 12:1, preferably from 1:1 to 8:1, more preferably from 1:1 to 4:1.

Sources of tin ions include, but are not limited to salts, such as tin halides, tin sulfates, tin alkane sulfonates, tin alkanol sulfonates, and acids. The tin compounds are generally commercially available or can be prepared by methods known in the literature. The amount of tin salts used in the bath depends on the desired composition of the alloy to be deposited and operating conditions. In general, tin salts may range from 0.1 g/L to 80 g/L.

The silver/tin alloy electroplating baths can also include one or more conventional bath additives which include, but are not limited to acid/electrolytes: alkanesulfonic acids, sulfuric acid, sulfamic acid and hydrochloric acid; stabilizers: mercaptotetrazoles and dihydroxy bis-sulfide compounds; suppressors: alkanol amines, polyethyleneimines and alkoxylated aromatic alcohols; reducing agents: hydroquinone, hydroquinone sulfonic acid, potassium salt and hydroxylated aromatic compounds; surfactants or wetting agents; brighteners: aromatic aldehydes; buffers and grain refiners. Such additives can be included in conventional amounts well known in the art.

Optionally, prior to plating silver/tin alloy on the copper or copper alloy layer the copper or copper alloy can be cleaned. Conventional metal cleaning processes can be used. Typically, the copper or copper alloy is ultrasonically cleaned in a cleaning solution or by cathodic degreasing. Such cleaning solutions can include silicate compounds, alkali metal carbonates and compounds such as alkali metal hydroxides, glycol ethers and one or more chelating agents. Cleaning may be done at temperatures of from 30° C to 80° C.

Optionally, following the cleaning step, the substrate can be activated with a suitable acid such as a mineral acid. Dilute concentrations of mineral acids are used. An example of such an acid is sulfuric acid. However, other mineral acids can be used such as hydrochloric acid and nitric acid. The acids are used at conventional concentrations well known in the art. Activation typically is done at temperatures from room temperature to 30° C.

Silver/tin alloy electroplating can be done at a current density of preferably 0.05 ASD or greater. More preferably the current density ranges from 0.5 ASD to 10 ASD. Bath temperatures are from room temperature to 55° C. The pH of the bath can range from less than 1 to 2. Silver/tin electroplating is done until a binary silver/tin alloy layer having, preferably, a thickness of 0.1 µm to 7 µm is achieved, more preferably the thickness is from 0.4 µm to 1.5 µm.

Optionally, the substrate with the silver/tin alloy adjacent to the copper or copper alloy is rinsed with DI water or tap water.

Palladium metal is electroplated to form a flash layer composed of palladium metal adjacent the binary silver/tin alloy layer. The flash layer can range in thickness preferably from 10 nm to 0.5 µm thick, more preferably from 15 nm to 0.1 µm, even more preferably from 30 nm to 0.1 µm.

The palladium flash layer can be electroplated adjacent the silver/tin layer using conventional palladium metal electroplating baths. Such palladium baths include, but are not limited to one or more sources of palladium ions. Sources of palladium ions include: dichlorodiammine palladium (II), dinitrodiammine palladium (II), tetrammine palladium (II) chloride, tetrammine palladium (II) sulfate, tetrammine palladium tetrachloropalladate, tetramine palladium carbonate, tetramine palladium hydrogen carbonate, palladium dichloride, palladium dibromide, palladium sulfate, palladium nitrate, palladium monoxide-hydrate, palladium acetates, palladium propionates, palladium oxalates and palladium formates. Such palladium compounds can be included in the baths in amounts to provide a palladium ion concentration of 10 g/L to 50 g/L.

The palladium electroplating baths can also include one or more conventional bath additives such as, but not limited to, alkali metal hydroxides: sodium hydroxide and potassium hydroxide; ammonium compounds: ammonium hydroxide and ammonium halides; organic and inorganic acids; stabilizers; buffers; brighteners; and surfactants. Such additives can be included in conventional amounts.

The palladium flash layer is electroplated adjacent the binary silver/tin alloy layer at current densities of preferably from 0.5 ASD to 75 ASD, more preferably from 0.5 ASD to 10 ASD, depending on metal concentration in the electroplating bath. Bath temperatures range from 40 to 70° C. The pH of the bath can range from 6 to 10.

The multi-layer electrical contact element of the of the present invention is composed, in succession, of a substrate with a layer of copper or copper alloy, optionally the substrate can be a dielectric material; a binary silver/tin alloy layer with a silver metal content of greater than 50% adjacent and joined to the copper or copper alloy layer; and a palladium flash layer adjacent and joined to the silver/tin alloy layer.

Optionally, a gold or gold alloy metal flash layer can be electroplated adjacent to the palladium flash layer. Preferably, the gold alloy is hard gold/cobalt or hard gold/nickel alloy. Preferably the hard gold/cobalt alloy is composed of 0.1wt% to 0.4wt% cobalt with the remainder gold and the hard gold/nickel alloy is composed of 0.1wt% to 1wt% nickel with the remainder gold. The gold or gold alloy flash layer ranges in thickness from 10 nm to 2 µm, preferably from 10 nm to 0.1 µm.

Gold and gold alloy can be deposited on the palladium metal layer using conventional gold and gold alloy electroplating baths. Sources of gold ions include, but are not limited to potassium gold cyanide, sodium dicyanoaurate (I), ammonium dicyanoaurate (I) and other dicyanoauric acid (I) salts; potassium tetracyanoaurate (III), sodium tetracyanoaurate (III), ammonium tetracyanoaurate (III) and other tetracyanoauric acid (III) salts; gold (I) cyanide, gold (III) cyanide; dichloroauric acid (I) salts; tetrachloroauric acid (III), sodium tetrachloroaurate (III) and other tetrachloroauric acid (III) compounds; ammonium gold sulfite, potassium gold sulfite, sodium gold sulfite and other sulfurous acid gold salts; gold oxide, gold hydroxide and other alkali metal salts thereof; and nitrosulphito gold complexes. The sources of gold typically are included in conventional amounts such as 0.1 gm/L to 10 g/L.

Gold and gold alloy electroplating baths also include conventional additives such as, but not limited to surfactants, brighteners, levelers, complexing agents, chelating agents, buffers, organic and inorganic acids and biocides. Such additives are included in conventional amounts and are well known to those of skill in the art.

Gold and gold alloy electroplating is done at current densities preferably from 0.1 ASD to 70 ASD, more preferably from 5 ASD to 70 ASD depending on the process and type of current such as DC or pulse current, and temperatures of 30 °C to 60 °C. The pH of the gold electroplating baths range from 4 to 8.

The multi-layer electrical contact element of the of the present is also composed, in succession, of a substrate with a layer of copper or copper alloy, optionally the substrate can be a dielectric material; a binary silver/tin alloy layer with a silver metal content of greater than 50% adjacent and joined to the copper or copper alloy layer; a palladium flash layer adjacent and joined to the silver/tin alloy layer; and a gold flash layer adjacent and joined to the palladium metal flash layer.

Optionally, a nickel metal layer can be electroplated directly adjacent to the copper or copper alloy layer prior to electroplating the binary silver/tin alloy to the multi-layer electrical contact element. The nickel metal layer has a thickness range of preferably 0.1 µm to 5 µm, more preferably from 0.5 µm to 2 µm.

The nickel layer can be electroplated from conventional nickel electroplating baths. Sources of nickel ions include, but are not limited to nickel halides such as nickel chloride; nickel sulfate and nickel sulfamate. Such sources of nickel ions are included in the nickel baths in amounts of 5 g/L to 250 g/L.

The nickel baths include conventional additives such as, but not limited to brighteners, grain refiners, levelers, surface active agents, anti-pitting agents, chelating agents, buffers, biocides and other additives known to those of skill in the art.

Nickel plating is done at current densities preferably from 1 ASD to 10 ASD and at bath temperatures of 30 °C to 70 ° C. The pH of the nickel bath can range from 2 to 8.

After the nickel is electroplated on the copper or copper alloy, the binary silver/tin alloy is electroplated on the nickel layer to the same thickness as described above and the same plating parameters to deposit a binary silver/tin alloy adjacent to the nickel metal layer. The palladium flash layer is then electroplated adjacent to the silver/tin alloy as described above.

The multi-layer electrical contact element of the of the present invention is further composed, in succession, of a copper or copper alloy layer, optionally the copper or copper alloy layer can be joined to a dielectric base; a nickel layer adjacent and joined to the copper or copper alloy layer; a binary silver/tin alloy layer with a silver metal content of greater than 50% adjacent and joined to the nickel layer; and a palladium flash layer adjacent and joined to the silver/tin alloy layer.

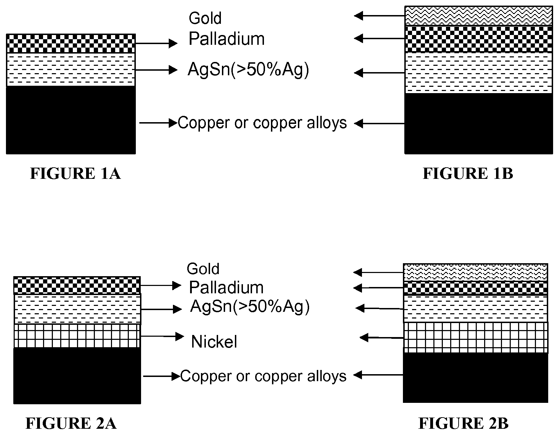

Figures 1A-B illustrate a multi-layer electrical contact element of the present invention with a copper or copper alloy layer (optional dielectric base not shown); a silver/tin alloy layer joined to the copper or copper alloy layer where the silver content of the silver/tin alloy is greater than 50% by weight; and a palladium metal flash layer joined to the silver/tin layer. Figure 1B further illustrates a multi-layer electrical contact element of the present invention where the optional gold layer is adjacent to the palladium metal flash layer.

Figures 2A-B illustrate a multi-layer electrical contact element of the present invention with a copper or copper alloy layer (optional dielectric base not shown); a nickel layer joined to the copper or copper alloy layer; a silver/tin alloy layer joined to the nickel layer where the silver content of the silver/tin alloy is greater than 50% by weight; and a palladium metal flash layer joined to the silver/tin layer. Figure 2B further illustrates a multi-layer electrical contact element of the present invention where the optional gold layer is adjacent to the palladium metal flash layer.

The optional dielectric base can be made from various non-conductive and semiconductive materials. Such materials include, but are not limited to thermoplastic resins and thermosetting resins.

Thermoplastic resins include, but are not limited to acetal resins, acrylics, such as methyl acrylate, cellulosic resins, such as ethyl acetate, cellulose propionate, cellulose acetate butyrate and cellulose nitrate, polyethers, nylon, polyethylene, polystyrene, styrene blends, such as acrylonitrile styrene and copolymers and acrylonitrile-butadiene styrene copolymers, polycarbonates, polychlorotrifluoroethylene, and vinylpolymers and copolymers, such as vinyl acetate, vinyl alcohol, vinyl butyral, vinyl chloride, vinyl chloride-acetate copolymer, vinylidene chloride and vinyl formal.

Thermosetting resins include, but are not limited to allyl phthalate, furane, melamine-formaldehyde, phenol-formaldehyde and phenol-furfural copolymers, alone or compounded with butadiene acrylonitrile copolymers or acrylonitrile-butadiene-styrene copolymers, polyacrylic esters, silicones, urea formaldehydes, epoxy resins, allyl resins, glyceryl phthalates and polyesters.

The multi-layer electrical contact elements of the present invention can be used in printed wiring boards, connectors, chip cards, lead frames and in IC units which are included in various electronic devices.

The following examples are included to further illustrate the present invention but are not intended to limit its scope.

### Examples 1-8

A plurality of copper coated resin substrates with areas of 1.4 dm² were electroplated with layers of binary silver/tin alloy, wherein the silver content of the alloy was 80wt% and the tin content was 20wt%. Four (Examples 1-4) of the substrates plated with the binary silver/tin layers were further electroplated with palladium flash layers and eight (Comparative Examples 1-8) were further electroplated with gold flash layers.

Plating was done according to the following procedure:
1- Cathodic Degreasing of copper substrate in RONACLEAN^{™} DLF cleaning solution (5 A, 1 min).
2- Water rinsed.
3- Activation of the substrate in RONASALT^{™} 369 solution (20 second immersion).
4- Water rinsed.
5- Silver/tin plating was done by using the electrolytic bath disclosed in Table 1 below. The silver/tin alloy layer was plated on the copper of the resin substrate at 50 °C using a current density of 2 ASD. The plating time was adjusted to plate the desired thickness. The time was 30 sec for 0.5 micron, 45 sec for 0.75 micron and 1 min for one micron. The anode was a platinized titanium electrode.
6- Water rinse.
7- Palladium or gold flash layer plating:
   For palladium flash layer, the bath with the composition disclosed in Table 2 was used. Electroplating a palladium flash layer on the silver/tin alloy was done at 45 °C using a current density of 1 ASD. The deposition time was adjusted to obtain the desired thickness. The time was 8 sec for 0.05 micron and 15 sec for 0.1 micron of palladium. The anode was a platinized titanium electrode.
   For pure gold plating, the bath with the composition in Table 3 was used. Plating a gold flash layer on the silver/tin alloy was done at 52 °C with a current density of 0.5 ASD for 8 sec for a 0.05 micron layer or 16 sec for 0.1 micron layer of gold. The anode was a platinized titanium electrode.
8- Water rinse.
9- Air dry.

### Thickness measurements of metal layers:

The thickness of the metal layers were measured by using a FISHERSCOPE™ X-ray fluorescence apparatus, model XDV-SD.

**Table 1**

| **COMPONENT** | **CONCENTRATION** |
|---|---|
| Silver ions from silver methane sulfonate | 60 g/L |
| Tin ions from tin methane sulfonate | 15 g/L |
| Methane sulfonic acid | 162 g/L |
| 1-(2-Dimethylaminoethyl)-5-mercapto-1,2,3,4-tetrazole | 150 g/L |
| 3,6-dithiaoctane-1,8-diol | 22 g/L |
| Amine oxide surfactant | 3 g/L |
| Hydroquinone monosulfonic acid, potassium salt | 1.2 g/L |

The pH was less than 1.

**Table 2**

| **COMPONENT** | **CONCENTRATION** |
|---|---|
| Palladium ions from palladium diammonium dichloride | 15 g/L |
| Ammonium bromide | 6.13 g/L |
| Ammonium hydroxide sol (24.5 wt%) | 18.12 g/L |
| Ammonium chloride | 240 mg/L |
| Ammonium Phosphate | 75 g/L |
| 3-pyridine sulfonic acid | 512 mg/L |
| Benzyl chloride | 9.6 mg/L |
| Sodium hydroxide | 3.2 mg/L |

The pH was 7.5.

**Table 3**

| **COMPONENT** | **CONCENTRATION** |
|---|---|
| Gold ions as potassium gold cyanide | 8 g/L |
| Hydroxyethylene-1,1- diphosphonic acid | 113.3 g/L |
| Potassium dihydrogen phosphate | 78.8 g/L |
| Potassium hydroxide | 63.75 g/L |
| Acetic acid 99 % | 7.6 mg/L |
| Lead (II) acetate trihydrate | 9.15 mg/L |

The pH was 6.2.

After electroplating the metal layers on the copper layers of the copper coated resin substrates, the corrosion inhibiting performance of the palladium and gold flash layers for the underlying silver/tin layers were tested using standard conventional humidity and neutral salt-spray tests.

### Humidity test: (HT)

The 500 hour accelerated moisture test was performed at 85 °C and 85 % relative humidity by using Vötsch Industrietechnik model VCL 4003 humidity chamber. Neutral salt-Spray test (NSS): The 96 hour neutral salt spray test was performed according to the DIN 50 021 standard (DIN refer to German Institute of Norm) by using the Weiss Umwelttechnik GmbH SC 450 salt spray equipment.

The results of the corrosion tests are disclosed in Table 4 below.

**Table 4**

| **Metal Layer** | **Example 1** | **Example 2** | **Example 3** | **Example 4** | **Example 5 (Comp.)** | **Example 6a +6b (Comp.)** | **Example 7 (Comp.)** | **Example 8a+8b (Comp.)** |
|---|---|---|---|---|---|---|---|---|
| Ag/Sn | 0.5 µm | 0.75 µm | 1 µm | 0.5 µm | 0.5 µm | 0.75 µm + 1 µm | 0.5 µm | 0.75 µm + 1 µm |
| Pd | 0.05 µm | 0.05 µm | 0.05 µm | 0.1 µm | ------ | ------ | ------ | ------ |
| Au | | | | | 0.05 µm | 0.05 µm | 0.1 µm | 0.1 µm |
| **Test** | ------ | ------ | ------ | ------ | ------ | ------ | ------ | ------ |
| NSS | passed | passed | passed | passed | passed | passed | passed | passed |
| HT | passed | passed | passed | passed | failed | failed | failed | failed |

All the samples passed the neutral salt spray test showing their ability to withstand sodium chloride corrosion. There was no indication of any corrosion. In contrast, the samples which included the gold flash layer on the silver/tin alloy layers failed the HT test. All showed some corrosion. The corrosion was indicated by green spots observed on the surface of the gold flash layer. All of the samples which included the palladium flash layer passed the HT test. There was no observable corrosion. Accordingly, the samples which included the palladium flash layer showed improved corrosion inhibition performance over the samples which included the gold flash layer.

### Example 9

Two 0.05 mm thick copper foils were electroplated with layers of nickel and then the nickel layers were electroplated with binary silver/tin alloy layers, wherein the silver content of the alloy was 80wt% and the tin content was 20wt%. A palladium flash layer was then electroplated on one of the binary silver/tin alloy layers of the two samples. Both foils were then electroplated with a gold flash layer as the top layer.

Plating was done according to the following procedure:
1- Cathodic Degreasing of copper substrate in RONACLEAN^{™} DLF cleaning solution (5 A, 1 min).
2- Water rinsed.
3- Activation of the substrate in RONASALT^{™} 369 solution (20 second immersion).
4- Water rinsed.
5- Nickel plating was done by using the electrolytic bath disclosed in Table 5 below. Nickel was plated at 55 °C and a current density of 4ASD for 2 min to deposit a 1.5 µm thick layer of nickel. The anode was a soluble nickel electrode.
6- Water rinse.
7- Silver/tin plating was done by using the electrolytic bath disclosed in Table 1 above in Examples 1-8. The silver/tin alloy layer was plated on the nickel layers at 50 °C using a current density of 2 ASD. Silver/tin alloy plating was done until a 4 µm thick layer of silver/tin was deposited on the nickel. The anode was a platinized titanium electrode.
8- Water rinse.
9- Palladium or gold flash layer plating:
For palladium flash layer, the bath with the composition disclosed in Table 2 above in Examples 1-8 was used. Electroplating a palladium flash layer on the silver/tin alloy was done at 45 °C using a current density of 1 ASD. Palladium plating was done until a 0.1 micron layer was deposited on the silver/tin alloy. The anode was a platinized titanium electrode.
For pure gold plating, the bath with the composition in Table 3 above was used. Plating a gold flash layer on the silver/tin alloy was done at 52 °C with a current density of 0.5 ASD until a 0.1 micron layer of gold was deposited. The anode was a platinized titanium electrode.
10- Water rinse.
11- Air dry.

**Table 5**

| **COMPONENT** | **CONCENTRATION** |
|---|---|
| Nickel (from NiSO₄.6H₂O) | 71 g/L (as Ni) |
| Nickel (from NiCl₂.6H₂O) | 11 g/L (as Ni) |
| Sodium allyl sulfonate | 7.5 g/L |
| Boric acid | 45 g/l |
| LUTENSIT™ AS 2230 surfactant¹ | 208 mg/L |

| | |
|---|---|
| ¹Available from BASF | |

The pH of the nickel bath was 4.2.

Both samples were placed in a conventional convection oven at 125 °C and annealed for 800 hours. After annealing was completed the samples were removed from the oven, allowed to cool to room temperature and then analyzed for their surface appearance. The sample which included the palladium flash layer retained a gold appearance on the surface. This indicated that the palladium layer inhibited diffusion of the gold into the silver/tin alloy layer. In contrast, the sample which had the gold flash layer but not the palladium flash layer appeared silver. This indicated that significant amounts of gold undesirably diffused into the silver/tin layer.

### Example 10

### Diffusion between Gold and Silver/Tin Alloy

Two 0.05 mm thick copper foils were electroplated with layers of nickel and then the nickel layers were electroplated with binary silver/tin alloy layers, wherein the silver content of the alloy was 80wt% and the tin content was 20wt%. A palladium flash layer was then electroplated on one of the binary silver/tin alloy layers of the two samples. Both foils were then electroplated with a gold flash layer. In addition, both samples were plated with a top layer of nickel. The top layer of nickel was plated on the gold to protect the gold layer from damage during sectioning of the samples.

Plating was done according to the following procedure:
1- Cathodic Degreasing of copper substrate in RONACLEAN^{™} DLF cleaning solution (5 A, 1 min).
2- Water rinse.
3- Activation of the substrate in RONASALT^{™} 369 solution (20 second immersion).
4- Water rinse.
5- Nickel plating was done by using the electrolytic bath disclosed in Table 5 above in Example 9. Nickel was plated at 55 °C and a current density of 4ASD for 2 min. The anode was a soluble nickel electrode.
6- Water rinse.
7- Silver/tin plating was done by using the electrolytic bath disclosed in Table 1 above in Examples 1-8. The silver/tin alloy layer was plated on the nickel layers at 50 °C using a current density of 2 ASD. Silver/tin alloy plating was done until a 4 µm thick layer of silver/tin was deposited on the nickel. The anode was a platinized titanium electrode.
8- Water rinse.
9- Palladium or gold flash layer plating:
   For palladium flash layer, the bath with the composition disclosed in Table 2 above in Examples 1-8 was used. Electroplating a palladium flash layer on the silver/tin alloy was done at 45 °C using a current density of 1 ASD. Palladium plating was done until a 0.05 micron layer was deposited on the silver/tin alloy. The anode was a platinized titanium electrode.
   For pure gold plating, the bath with the composition in Table 3 above was used. Plating a gold flash layer on the silver/tin alloy was done at 52 °C with a current density of 0.5 ASD until a 1.5 micron layer of gold was deposited. The anode was a platinized titanium electrode. A thicker gold layer was deposited on these samples to make the gold layers more visible upon cross-sectioning the samples for the analysis described below.
10- Nickel plating was done by using the electrolytic bath disclosed in Table 5 above in Example 9. Nickel was plated at 55 °C and a current density of 4ASD for 2 min. to deposit a nickel top layer on the gold layer of each sample 0.6 µm for the data in Table 6 and 0.2 µm for the data in Table 7. The anode was a soluble nickel electrode.
11-Water rinse.
12- Air dry.

Both samples were then annealed according to the method described in Example 9 above. After annealing the samples were allowed to cool to room temperature. Both samples were cross-sectioned and analyzed for elemental content of the metal layers using a ZEISS™ SmartSEM V 05.04 scanning electron microscope equipped with EDX detector. The results of the elemental analysis of the different metal layers for the sample without the palladium flash layer and with the palladium flash layer adjacent the binary silver/tin layer are in Tables 6 and 7, respectively.

Each point (p) or depth was measured from the top of the top nickel layer. Six points were measured to determine element content for the sample which excluded the palladium flash layer (Table 6) and seven points were measured to determine element content for the sample which had the flash palladium layer (Table 7).

**Table 6**

| **Elements (wt%)** | **C** | **N** | **O** | **Ni** | **Ag** | **Sn** | **Au** |
|---|---|---|---|---|---|---|---|
| p1 = 1.6 µm in Au layer | 9.8 | | 0.3 | 1.4 | 8.7 | 4.0 | 75.8 |
| p2 = 1.3 µm in Au layer | 9.1 | | 3.1 | 8.7 | 5.8 | 3.2 | 70.1 |
| p3 = 3 µm in Ag/Sn layer | 6.7 | 1.3 | | 1.3 | 28.3 | 3.7 | 58.6 |
| p4= 4.1 µm in Ag/Sn layer | 4.2 | | | | 63.1 | 17.4 | 15.3 |
| p5 = 6 µm interface of Ag/Sn and Ni layers | 3.5 | | | 0.9 | 71.2 | 19.2 | 5.2 |

Mixed crystals of silver and tin were observed at the interface between the silver/tin and gold layers and silver and tin were also present in the gold layer of the sample which excluded the palladium flash layer. Gold was detected in the silver/tin layer.

As shown in Table 6 elemental gold in amounts of 75.8 wt% and 70.1 wt% were measured at p1 and p2, respectively, in the gold layer. Gold was also measured in amounts of 58.6 wt% and 15.3 wt% at p3 and p4, respectively, within the silver/tin alloy layer indicating undesirable significant interdiffusion of gold into this alloy layer. Gold also penetrated down to the interface of the silver/tin layer and nickel layer adjacent the copper in amounts of 5.2 wt% as shown at p5. In addition, silver in amount of 8.7% and 5.8% was detected at p1 and p2, respectively, which were in the gold layer. This indicated undesirable diffusion of silver into the gold layer.

**Table 7**

| **Elements (wt%)** | **C** | **N** | **O** | **Ni** | **Cu** | **Ag** | **Sn** | **Au** |
|---|---|---|---|---|---|---|---|---|
| p1 = 0.5 µm in Au layer | 9.1 | | | | | | | 90.9 |
| p2= 2.4 µm in Ag/Sn layer | 2.7 | | | | | 76.2 | 17.9 | 3.2 |
| p3 = 3.1 µm Ag/Sn layer adjacent to interface with Pd | 2.3 | 1.5 | | | 1.6 | 72.3 | 18.2 | 4.0 |
| p4 = 3.9 µm in Ag/Sn layer | 2.1 | | | 1.5 | 1.7 | 72.8 | 18.1 | 3.7 |
| p5= 5.5 µm in Ni layer | 5.9 | | | 91.5 | | | | 2.6 |
| p6 = 1.9 µm adjacent Ag/Sn and Au interface | 5.5 | | | | | 32.1 | 37.8 | 24.7 |
| p7= 0.5 µm in Au layer | 6.3 | | 0.4 | | | | | 93.3 |

The cross-section of the sample which included the palladium flash layer (only 5 nm thick after annealing) had a sharp interface between the gold and silver/tin alloy layers. There were no observable mixed crystals of silver and tin at the interface between the silver/tin and gold layers nor silver and tin in the gold layer of the sample which excluded the palladium flash layer. As shown in Table 7, gold in amounts of 3.2 wt%, 4 wt% and 3.7 wt% at p2, p3 and p4, respectively, were measured in the silver/tin layer. Such amounts were negligible (almost at the point of the detection limit of EDX) in contrast to the amount of gold measured in the silver/tin layer of the sample which excluded the palladium layer. Substantially all of the gold remained in the gold layer as shown at p1 and p7. The palladium flash layer significantly inhibited gold diffusion into the silver/tin layer.

## Claims

1. A multi-layer electrical contact element comprising:
a substrate comprising a copper or copper alloy layer;
a binary silver/tin alloy layer upon the copper or copper alloy layer, the binary silver/tin alloy layer comprises at least 50% by weight silver; and
a flash layer composed of palladium adjacent the binary silver/tin alloy layer.

2. The multi-layer electrical contact element of claim 1, wherein the multi-layer electrical contact element further comprises a nickel layer between the copper or copper alloy layer and the binary silver/tin alloy layer.

3. The multi-layer electrical contact element of claim 2, wherein the nickel layer is 0.1 µm to 5 µm thick.

4. The multi-layer electrical contact element of claim 1, wherein the multi-layer electrical contact element further comprises a gold or gold alloy layer adjacent the palladium layer.

5. The multi-layer electrical contact element of claim 4, wherein the gold or gold alloy layer is 10 nm to 2 µm thick.

6. The multi-layer electrical contact element of claim 1, wherein the binary silver/tin alloy layer is 0.1 µm to 7 µm thick.

7. The multi-layer electrical contact element of claim 1, wherein the palladium layer is 10 nm to 0.5 µm thick.

8. The multi-layer electrical contact element of claim 1, wherein the binary silver/tin alloy is composed of 80% by weight silver and 20% by weight tin.

9. The multi-layer electrical contact element of claim 1, wherein the binary silver/tin alloy is composed of 70% to 95% by weight silver and 5% by weight to 30% by weight tin.

10. A method of forming a multi-layer electrical contact element comprising:
a) providing a substrate comprising a copper or copper alloy layer;
b) electroplating a binary silver/tin alloy layer adjacent the copper or copper alloy layer of the substrate from a silver/tin alloy electroplating bath, the binary silver/tin alloy comprises at least 50% by weight silver; and
c) electroplating a flash layer of palladium adjacent the binary silver/tin alloy from an electroplating bath comprising palladium ions.

11. The method of forming a multi-layer electrical contact element of claim 10, further comprising electroplating a gold layer adjacent the flash layer of palladium with a gold electroplating bath.

12. A method of forming a multi-layer electrical contact element comprising:
a) providing a substrate comprising a copper or copper alloy layer;
b) electroplating a nickel layer adjacent the copper or copper alloy layer of the substrate from a nickel electroplating bath;
c) electroplating a binary silver/tin alloy layer adjacent the nickel layer from a silver/tin alloy electroplating bath, the binary silver/tin alloy comprises at least 50% by weight silver; and
d) electroplating a flash layer of palladium adjacent the binary silver/tin alloy from a palladium electroplating bath.

13. The method of forming a multi-layer electrical contact element of claim 12, further comprising electroplating a gold layer adjacent the flash layer of palladium with a gold electroplating bath.
